# FASCICULE DE BREVET EUROPEEN

(11) **EP 2 673 873 B1**
(45) Date de publication et mention de la délivrance du brevet: **03.12.2014**
(21) Numéro de dépôt: 12702236.6
(22) Date de dépôt: 31.01.2012
(51) Int. Cl.: H02N 2/18, H01L 41/113

(54) **DISPOSITIF DE CONVERSION D'ENERGIE MECANIQUE EN ENERGIE ELECTRIQUE OPTIMISE**
OPTIMIERTE VORRICHTUNG ZUR UMWANDLUNG VON MECHANISCHER ENERGIE IN ELEKTRISCHE ENERGIE
OPTIMIZED DEVICE FOR CONVERTING MECHANICAL ENERGY INTO ELECTRICAL ENERGY

(30) Priorité: 11.02.2011 FR 1151156
(43) Date de publication de la demande: 18.12.2013
(73) Titulaire: Commissariat à l'Énergie Atomique et aux Énergies Alternatives, 75015 Paris (FR)
(72) Inventeur: AHMED SEDDIK, Bouhadjar, F-38100 Grenoble (FR); DEFAY, Emmanuel, F-38340 Voreppe (FR); DESPESSE, Ghislain, F-38120 Saint Egreve (FR)
(74) Mandataire: Guérin, Jean-Philippe
(86) Numéro de dépôt international: PCT/EP2012/051593
(87) Numéro de publication internationale: WO 2012/107327

(56) Documents cités:
- EP-A2- 2 109 217
- WO-A2-02/43163
- US-A1- 2003 214 200
- US-A1- 2010 270 889
- "DuPont(TM) Teijin Films Mylar(R) MBP Polyester Film, 92 Gauge (32 µm)", MatWeb, XP002648345, Extrait de l'Internet: URL:http://www.matweb.com/search/DataSheet .aspx?MatGUID=fd5659dc8b5242c9bbfb91d79808 aff9&ckck=1 [extrait le 2011-07-07]
- "Overview of materials for Polyvinylidinefluoride (PVDF), Molded/Extruded", MatWeb, XP002648346, Extrait de l'Internet: URL:http://www.matweb.com/search/DataSheet .aspx?MatGUID=a011f8ccf4b448a19246773a3208 5094 [extrait le 2011-07-07]
- "Raideur (mécanique)", Wikipedia, XP002648347, Extrait de l'Internet: URL:http://fr.wikipedia.org/wiki/Raideur_% 28m%C3%A9canique%29 [extrait le 2011-07-07]
- "Moment quadratique", Wikipedia, XP002648348, Extrait de l'Internet: URL:http://fr.wikipedia.org/wiki/Moment_qu adratique [extrait le 2011-07-07]

## Description

L'invention concerne les dispositifs de conversion d'énergie mécanique en énergie électrique, et en particulier les dispositifs d'alimentation autonome générant une énergie électrique à partir d'un mouvement vibratoire.

Dans certains environnements, il peut être délicat de connecter un circuit électrique à des câbles d'alimentation, par exemple dans des milieux hostiles ou sur des mécanismes en mouvement. Pour pallier ce problème, des dispositifs micromécaniques de conversion d'énergie vibratoire en énergie électrique sont connus. Ces dispositifs forment des microsystèmes généralement accolés sur des supports vibrants, tels que des machines industrielles ou des véhicules. Selon une technique connue, on utilise un système résonant pour amplifier une vibration mécanique d'un support et convertir le mouvement amplifié en électricité. Le circuit électrique peut ainsi être alimenté sans faire appel à des câbles provenant de l'extérieur.

Un des principes connus pour transformer de l'énergie mécanique vibratoire en énergie électrique est basé sur l'excitation vibratoire d'une poutre pourvue d'éléments piézo-électriques. Une telle poutre présente généralement un noyau ayant une première extrémité encastrée dans un support vibrant. Une masse mobile est fixée à la deuxième extrémité du noyau. Un élément piézo-électrique est fixé sur la face supérieure du noyau, un autre élément piézo-électrique est fixé sur la face inférieure du noyau. Un circuit électrique est connecté aux bornes des éléments piézo-électriques placés électriquement en série ou parallèle. Le noyau est généralement composé d'un matériau dur qui présente un très bon facteur de qualité, tel que de l'Acier ou du Silicium. Le noyau est généralement de section transversale rectangulaire et constante. Les éléments piézoélectriques, sont destinés à convertir l'énergie mécanique transmise par la masse mobile en énergie électrique.

Lors d'un déplacement relatif entre le support et la masse mobile, l'effort d'accélération de la masse mobile induit alors un moment de flexion le long de la poutre. Ce moment de flexion n'est pas constant le long de la poutre (le moment étant plus élevé au niveau de l'encastrement qu'au niveau de la masse). Avec un noyau de section constante sur toute sa longueur, la contrainte mécanique dans les faces supérieure et inférieure du noyau et à l'intérieur des éléments piézoélectriques n'est pas homogène sur leur longueur, cette contrainte étant concentrée au niveau de l'encastrement. Par ailleurs, la contrainte mécanique n'est pas homogène non plus dans l'épaisseur du noyau: plus on s'éloigne de la ligne centrale (fibre neutre), plus la contrainte mécanique est importante. Dans le cas de noyaux multicouches, l'énergie mécanique transmise par le support vibrant vers le noyau se répartit donc de manière non-uniforme entre les couches.

Comme les éléments piézo-électriques sont limités dans leur utilisation par une tension mécanique de dépolarisation maximale à ne pas dépasser, la non uniformité des contraintes sur leur longueur conduit à sur-dimensionner les éléments piézo-électriques de façon à ne pas dépasser un certain niveau de contrainte en tout point, même si la majeure partie de leur longueur est peu contrainte. Par conséquent, les zones d'un élément piézo-électrique supportant une moindre contrainte (par exemple au niveau de la jonction avec la masse mobile) s'avèrent surdimensionnées. Durant une déformation, ces zones moins contraintes forment même une capacité parasite recueillant des charges générées dans les zones plus contraintes. La quantité d'énergie électrique transmise par les éléments piézo-électriques au circuit électrique est ainsi réduite.

Par ailleurs, les éléments piézo-électriques sont utilisés selon la direction longitudinale de la poutre, correspondant à la direction selon laquelle une traction et/ou une compression leur est appliquée lors de la flexion de la poutre. Les charge électrique générées sont alors collectées soit avec des électrodes situées aux deux extrémités longitudinales du piézoélectrique (polarisation du piézoélectrique dans sa direction longitudinale), soit avec des électrodes placées sur les faces supérieure et inférieure du piézoélectrique (polarisation du piézoélectrique dans sa direction transversale). Pour une poutre d'une longueur non négligeable, les éléments piézo-électriques doivent être dimensionnés de façon appropriée pour éviter de générer une tension trop élevée entre leurs extrémités/électrodes, afin d'éviter la formation d'arcs électriques sur leurs bords ou d'éviter d'atteindre leur tension de dépolarisation. La zone des éléments piézoélectriques générant le plus d'électricité est celle qui supporte la plus forte contrainte mécanique, à proximité de l'encastrement. Certains dispositifs de conversion proposent ainsi de ne placer des éléments piézoélectriques qu'au niveau de l'encastrement.

Afin d'homogénéiser la contrainte dans les éléments piézo-électriques sur la longueur de la poutre, le document rédigé par Goldschmidtböing, Müller et Woias intitulé 'optimization of resonant harvesters in piezopolymer-composite technology' publié aux pages 49-51 du fascicule distribué lors du congrès Proceeding PowerMEMS des 28-29 Novembre 2007, décrit un dispositif de conversion d'énergie à poutre munie d'un noyau en silicium et d'un élément piézo-électrique en PZT fixé sur la face supérieure du noyau. Le noyau en silicium et l'élément piézo-électrique présentent une épaisseur constante mais une largeur croissante entre leurs extrémités fixées à la masse mobile et leurs extrémités fixées au support vibrant. Ainsi, la contrainte dans l'élément piézo-électrique est homogénéisée sur la longueur de la poutre.

Par ailleurs, la fréquence de résonance mécanique d'un système résonant peut être modifiée en contrôlant la polarisation de l'élément piézo-électrique. Le module d'élasticité (ou module d'Young) de l'élément piézo-électrique peut ainsi être modifié de manière active pour modifier sa raideur en compression/traction et par conséquent la raideur en flexion de la poutre, et ainsi influer sur la fréquence de résonance mécanique du système résonant. On peut ainsi réaliser un asservissement de la fréquence de résonance mécanique du système. Un tel asservissement peut s'avérer nécessaire lorsque le système dont on extrait l'énergie vibratoire présente une fréquence vibratoire variable, par exemple sur un véhicule automobile dans lequel la vitesse de rotation du moteur ou la vitesse de rotation des roues connaît de grandes variations.

Une telle adaptation de la fréquence de résonance, adaptée à l'exemple précédant, induit un certain nombre de problèmes. Le noyau de la poutre est réalisé en un matériau présentant un facteur de qualité élevé pour réduire l'amortissement mécanique du dispositif de conversion, mais ces matériaux présentent généralement un module d'élasticité élevé (silicium, acier) augmentant l'énergie mécanique stockée dans le substrat au détriment de celle stockée dans les éléments piézoélectriques, réduisant ainsi le couplage électromécanique de la poutre complète et donc la capacité à modifier la fréquence de résonance de la structure par une modification de la polarisation électrique des éléments piézoélectriques ou de la charge électrique qui lui est connectée. De plus, le noyau est avantageusement relativement épais par rapport aux éléments piézoélectriques, pour éviter que la déformation de la poutre n'induise des contraintes essentiellement de cisaillement dans les éléments piézoélectriques, ces contraintes de cisaillement étant défavorables à une génération optimale d'une tension électrique dans l'élément piézo-électrique. Le noyau présente ainsi une épaisseur et un module d'élasticité supérieurs à ceux de l'élément piézo-électrique. Par conséquent, la raideur en flexion de la poutre est essentiellement définie par la raideur en flexion du noyau. Comme le module d'élasticité de l'élément piézo-électrique ne peut varier que d'environ 20 %, la variation de la raideur en flexion globale de la poutre obtenue en contrôlant la polarisation de l'élément piézo-électrique est relativement réduite. Par conséquent, la fréquence de résonance mécanique du dispositif de conversion ne peut être contrôlée que dans une plage relativement réduite. Un compromis entre l'amortissement mécanique de la poutre et l'amplitude de sa plage de fréquence de résonance est donc nécessaire.

Le document EP2109217 décrit un dispositif de récupération d'énergie vibratoire réglable. Le dispositif de récupération d'énergie comprend une poutre. La poutre est munie d'un corps principal, d'au moins un rabat, et d'au moins des moyens pour modifier la forme du rabat. Le rabat est physiquement attaché au corps principal le long d'un côté longitudinal du corps. La forme du rabat est modifiée pour modifier la rigidité de la structure.

L'invention vise à résoudre un ou plusieurs de ces inconvénients. L'invention porte ainsi sur un dispositif de conversion d'énergie mécanique vibratoire en énergie électrique, comprenant :
- une masse mobile ;
- un support ;
- une première poutre s'étendant longitudinalement entre le support et la masse mobile, la première poutre ayant ses extrémités encastrées respectivement dans le support et dans la masse mobile, la première poutre présentant une première raideur en élongation selon la direction longitudinale.

Le dispositif comprend en outre :
- une deuxième poutre en matériau piézo-électrique s'étendant longitudinalement entre le support et la masse mobile, le support et la masse mobile étant reliés par l'intermédiaire de la deuxième poutre, la deuxième poutre présentant une deuxième raideur en élongation selon la direction longitudinale inférieure à la première raideur ;
- un premier élément de jonction s'étendant entre les première et deuxième poutres, cet élément de jonction maintenant l'écartement entre les première et deuxième poutres, la raideur à la flexion de l'ensemble comportant la première poutre, la deuxième poutre et l'élément de jonction étant au moins double de la raideur à la flexion de ce même ensemble dépourvu de la deuxième poutre.

Selon une variante, le premier élément de jonction comprend une série de saillies s'étendant entre la première poutre et la deuxième poutre, les saillies étant formées d'un seul tenant avec la première poutre et étant séparées par des évidements.

Selon une autre variante, le premier élément de jonction comprend une couche de matériau joignant la première poutre à la deuxième poutre et présentant une raideur en élongation inférieure à la deuxième raideur en élongation.

Selon encore une variante, les première et deuxième poutres s'étendent de façon sensiblement rectiligne selon des directions convergeant à l'intérieur de la masse mobile.

Selon encore une autre variante, la deuxième poutre forme un angle compris entre 2 et 4° par rapport à la première poutre.

Selon une variante, la masse mobile est maintenue suspendue dans un évidement du support par l'intermédiaire desdites première et deuxième poutres.

Selon une autre variante, la deuxième poutre comprend deux bornes de connexion au niveau de polarités piézoélectriques opposées, le dispositif comprenant en outre un circuit électrique connecté entre lesdites deux bornes de connexion.

Selon encore une variante, le circuit électrique présente un amortissement électrique sensiblement égal à l'amortissement mécanique d'une structure incluant la masse mobile, la première poutre, la deuxième poutre et l'élément de jonction.

Selon encore une autre variante, le circuit électrique présente une impédance variable, le dispositif comprenant en outre un circuit de commande apte à modifier l'impédance dudit circuit électrique.

Selon une variante, le circuit électrique présente une tension à ses bornes réglable, le dispositif comprenant en outre un circuit de commande apte à modifier la tension aux bornes dudit circuit électrique.

Selon une autre variante, le matériau piézo-électrique de la deuxième poutre est polarisé selon la direction longitudinale de cette poutre.

Selon encore une variante, la deuxième poutre comprend une succession d'éléments piézoélectriques fixés ensemble, deux éléments piézoélectriques successifs présentant des polarisations opposées.

Selon encore une autre variante, le dispositif comprend en outre :
- une troisième poutre en matériau piézo-électrique s'étendant longitudinalement entre le support et la masse mobile, la troisième poutre ayant ses extrémités encastrées respectivement dans le support et dans la masse mobile, la troisième poutre présentant une troisième raideur en élongation selon la direction longitudinale inférieure à la première raideur;
- un deuxième élément de jonction s'étendant entre les première et deuxième poutres, cet élément de jonction maintenant l'écartement entre les première et troisième poutres, la raideur à la flexion de l'ensemble comportant la première poutre, la deuxième poutre, la troisième poutre et les éléments de jonction étant au moins double de la raideur à la flexion de ce même ensemble dépourvu de la deuxième poutre.

Selon une autre variante, le système comprenant les première à troisième poutres, les premier et deuxième éléments de jonction et la masse mobile présente un plan de symétrie longitudinal tel que la deuxième poutre est symétrique à la troisième poutre par rapport à ce plan.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue en coupe longitudinale schématique d'un premier mode de réalisation d'un dispositif de conversion d'énergie mécanique vibratoire selon l'invention ;
- la figure 2 est une vue de dessus du dispositif de la figure 1 ;
- la figure 3 est une représentation schématique du déplacement d'une masse mobile du dispositif de la figure 1 lors d'un déplacement induit par une excitation vibratoire ;
- la figure 4 est une vue en coupe longitudinale schématique d'un second mode de réalisation d'un dispositif de conversion d'énergie mécanique vibratoire selon l'invention ;
- les figures 5 à 7 sont des vues en coupe longitudinale schématique de variantes du mode de réalisation de la figure 4;
- la figure 8 est une vue en coupe longitudinale schématique d'un troisième mode de réalisation d'un dispositif de conversion d'énergie mécanique vibratoire selon l'invention ;
- la figure 9 est une représentation agrandie du dispositif de conversion d'énergie mécanique de la figure 8 illustrant ses connexions avec un circuit électrique ;
- la figure 10 est une représentation schématique d'un modèle de dispositif de conversion d'énergie mécanique vibratoire utilisé pour déterminer un angle d'inclinaison optimale d'une poutre piézo-électrique ;
- la figure 11 est un diagramme illustrant la contrainte de traction/compression dans la poutre piézo-électrique du modèle de la figure 10, en fonction de l'emplacement longitudinal où cette contrainte est mesurée.

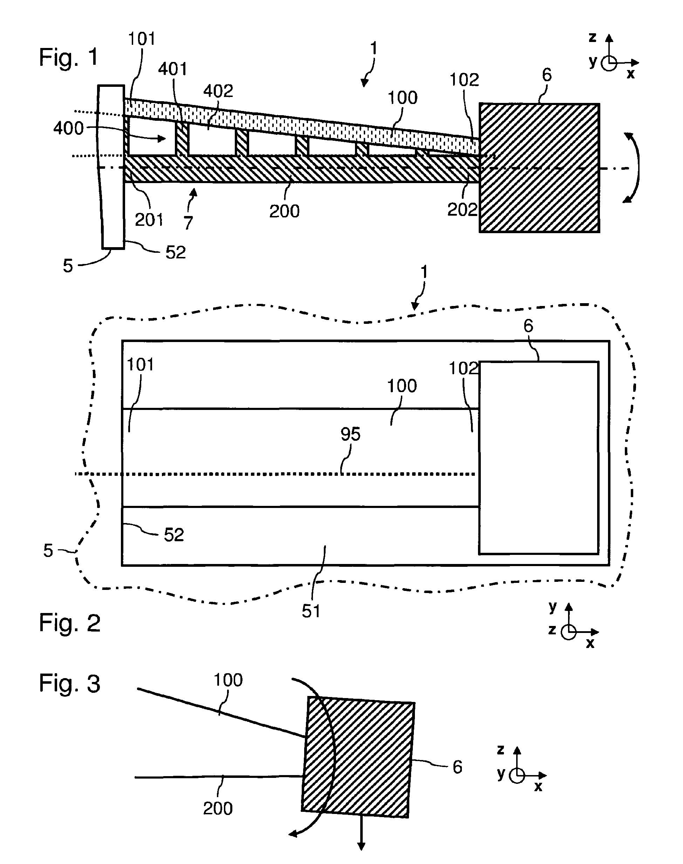

La figure 1 représente une vue en coupe longitudinale schématique d'un premier mode de réalisation d'un dispositif de conversion d'énergie mécanique vibratoire en énergie électrique 1. La figure 2 est une vue de dessus de ce même dispositif. Le dispositif 1 comprend un support 5 destiné à être solidarisé au système générateur de l'énergie vibratoire. Le dispositif 1 comprend également une masse mobile 6, logée dans un évidement 51 du support 5. Une première poutre 200 s'étend longitudinalement (selon l'axe x dans le repère illustré) entre le support 5 et la masse mobile 6. La première poutre 200 présente deux extrémités longitudinales 201 et 202. Les extrémités 201 et 202 sont encastrées respectivement dans le support 5 et dans la masse mobile 6. Une deuxième poutre 100 s'étend sensiblement longitudinalement entre le support 5 et la masse mobile 6. La deuxième poutre 100 présente deux extrémités longitudinales 101 et 102. Les extrémités 101 et 102 sont encastrées respectivement dans le support 5 et dans la masse mobile 6. La deuxième poutre 100 est en matériau piézo-électrique. Le matériau piézo-électrique présente une polarisation sensiblement longitudinale. Ainsi, une tension électrique est générée entre ses extrémités 101 et 102 lorsqu'il est soumis à une traction ou une compression longitudinale. L'extrémité 102 est connectée à un circuit à alimenter et à un circuit de commande de fréquence de résonance (non illustrés) par l'intermédiaire d'un câblage électrique 95. L'extrémité 101 est connectée à la masse du circuit à alimenter et du circuit de commande, par l'intermédiaire du support 5 formé dans un matériau rigide et qui présente un bon facteur qualité. Le support 5 peut être formé d'un substrat semi-conducteur. Dans l'exemple, la direction longitudinale est définie comme une direction perpendiculaire à la face 52 du support 5 sur laquelle les poutres 100 et 200 sont fixées.

Un élément de jonction 400 est disposé entre les poutres 100 et 200. L'association des poutres 100, 200 et de l'organe de jonction 400 forme une poutre 7. L'élément de jonction 400 correspond au volume présent entre les poutres 100 et 200, identifié par les lignes en pointillés. L'élément de jonction 400 s'étend entre les poutres 100 et 200. L'élément de jonction 400 est configuré pour maintenir un écartement entre les première et deuxième poutres, selon le principe d'une structure sandwich.

L'élément de jonction 400 est configuré de sorte que la raideur à la flexion de la poutre 7 autour de l'axe y soit au moins le double de la raideur à la flexion de cette poutre 7 dépourvue de poutre 100. Ainsi, la poutre 100 a une incidence prépondérante sur la raideur à la flexion de la poutre 7. On définit par raideur ou module de rigidité à la flexion d'une poutre par rapport à un axe, comme le produit du module d'élasticité de la poutre par son moment quadratique par rapport à cet axe. La raideur à la flexion relative de deux poutres pourra être mesurée en comparant la flèche de chacune de ces poutres face à une même charge appliquée à leur extrémité libre (extrémité destinée à être fixée à la masse mobile).

Dans l'exemple illustré, l'organe de jonction 400 est formé d'une alternance de saillies 401 s'étendant selon la direction z et d'évidements 402. Les saillies 401 sont formées monoblocs avec la poutre 200. La poutre 100 est fixée sur les extrémités des saillies 401, par exemple par collage. La présence des évidements 402 séparant les saillies 401 permet de former un élément de jonction 400 présentant une raideur à la flexion réduite malgré l'utilisation du même matériau que la poutre 200.

La masse mobile 6 est maintenue suspendue par l'intermédiaire des poutres 100 et 200 dans l'évidement 51 ménagé dans le support 5. Les poutres 100 et 200 et l'élément de jonction 400 sont configurés pour fléchir autour d'un axe de direction y sous l'effet du mouvement relatif entre la masse mobile 6 et le support 5 selon la direction z.

Selon le principe d'une structure sandwich, l'élément de jonction 400 maintient un écartement entre les poutres 100 et 200, est sollicité en cisaillement, et permet aux poutres 200 et 100 d'être sollicitée essentiellement en traction/compression. La présence d'un élément de jonction 400 de raideur à la flexion plus réduite entre les poutres 100 et 200 permet d'accroître l'incidence du module d'élasticité de la poutre 100 sur la raideur à la flexion globale de la poutre 7 du dispositif 1. Ainsi, si l'on fait varier activement le module d'élasticité de la poutre 100, on peut accroître la plage de variation de la fréquence de résonance mécanique du dispositif 1. Ainsi, des matériaux piézo-électriques relativement courants peuvent être utilisés tout en garantissant une plage de variation importante. Par ailleurs, les contraintes de traction/compression dans la poutre 100 sont accrues pour un même effort, ce qui permet d'optimiser la récupération d'énergie pour une vibration donnée du support 5. Pour accroître encore l'incidence de la poutre 100 sur la raideur de la poutre 7, l'élément de jonction 400 présente avantageusement un volume au moins égal au volume occupé par les poutres 100 ou 200.

La première poutre 200 présente une raideur à l'élongation supérieure à la raideur à l'élongation de la deuxième poutre 100 selon l'axe longitudinal. Ainsi, la poutre 200 garantit un facteur de qualité élevé du résonateur mécanique formé. La raideur à l'élongation de la première poutre 200 pourra notamment être obtenue par l'utilisation d'un matériau présentant un module d'élasticité élevé, tel que du silicium ou de l'acier. La raideur à l'élongation de la deuxième poutre 100 pourra notamment être obtenue par l'utilisation d'un matériau présentant un module d'élasticité inférieur à celui de la poutre 200, tel que du PZT ou du BaTiO₃.

Les poutres 100 et 200 pourront présenter sensiblement une forme de plaques. Ces plaques pourront par exemple présenter une épaisseur comprise entre 10 et 250 µm et pourront présenter une longueur comprise entre 5 et 50 mm.

La poutre 7 formée des poutres 100 et 200 et de l'élément de jonction 400 présente avantageusement une raideur face à une flexion autour de l'axe z nettement supérieure à la raideur face à la flexion autour de l'axe y.

Avantageusement, les poutres 100 et 200 sont sensiblement rectilignes ou planes et s'étendent selon des directions convergeant à l'intérieur de la masse mobile. Avantageusement, les poutres 100 et 200 s'étendent selon des directions convergeant au niveau du centre de gravité de la masse mobile 6.

Avantageusement, la masse mobile 6 présente une masse nettement supérieure à la masse de la poutre 7 formée des poutres 100 et 200 et de l'élément de jonction 400. Ainsi, la fréquence de résonance mécanique peut être fixée de façon plus aisée dans un volume restreint et l'essentiel de la masse subit un déplacement maximal permettant d'augmenter l'énergie cinétique associée et par conséquent la puissance électrique récupérable.

Avantageusement, le support 5, la masse mobile 6, la poutre 200 et les saillies 401 de l'élément de liaison sont formés d'un seul tenant, par exemple dans un substrat de silicium. Une telle configuration peut être réalisée aisément avec des techniques connues de mise en forme du silicium, en permettant d'obtenir des valeurs appropriées de modules d'élasticité pour un dispositif de conversion selon l'invention.

Avantageusement, la poutre 100 est inclinée par rapport à la poutre 200 et inclinée par rapport à la perpendiculaire à la face 52. Par une inclinaison appropriée de la poutre 100, dont un exemple de détermination est fourni ultérieurement, une flexion de la poutre 7 conduit à des contraintes sensiblement homogènes de traction/compression dans la poutre 100. On augmente ainsi le moment quadratique de la poutre au fur et à mesure que l'on s'éloigne de la masse mobile 6. Une répartition homogène de contraintes dans la longueur de la poutre 100 permet de bénéficier d'un dimensionnement optimal de celle-ci et d'optimiser à la fois la récupération d'énergie lors de la déformation du fait de l'absence de zones moins contraintes formant des capacités parasites, et l'incidence de la raideur de la poutre 100 sur la poutre 7,

Le circuit de commande de la fréquence de résonance comporte une charge électrique d'impédance réglable. En fonction de la fréquence de résonance mécanique souhaitée, le circuit de commande adapte l'impédance connectée aux bornes de la poutre piézo-électrique 100. Une impédance maximale (par exemple un circuit ouvert) aux bornes de la poutre piézo-électrique 100 définit une fréquence de résonance mécanique maximale, tandis qu'une impédance minimale (par exemple un court-circuit) aux bornes de la poutre piézo-électrique 100 définit une fréquence de résonance mécanique minimale.

Le circuit de commande définit avantageusement la fréquence de résonance mécanique pour que celle-ci soit proche de la fréquence de la vibration du support 5 et/ou adapte le coefficient d'amortissement électrique du circuit électrique connecté aux bornes de la poutre 100 pour que ce coefficient d'amortissement soit sensiblement égal au coefficient d'amortissement mécanique.

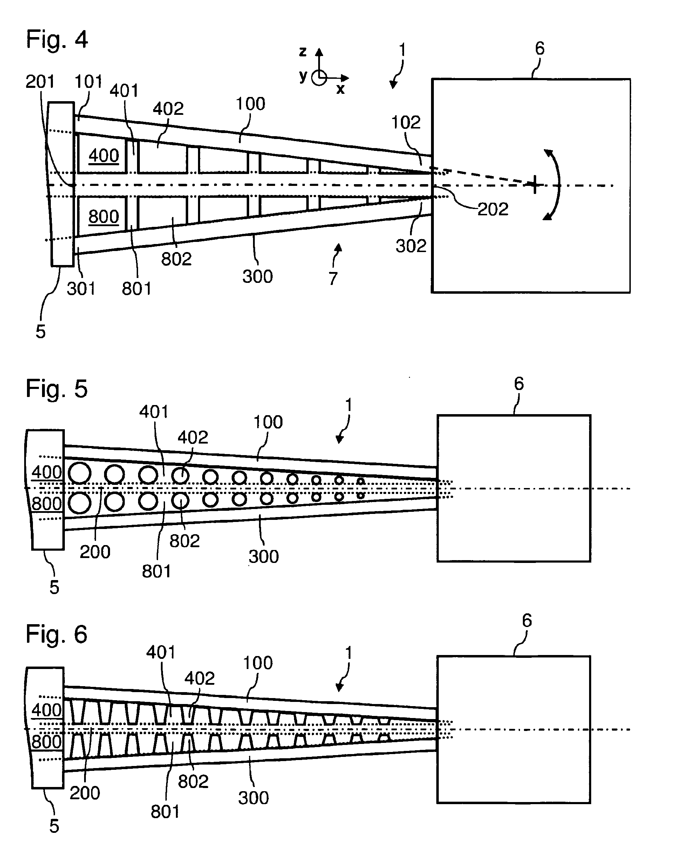

La figure 4 est une vue en coupe longitudinale schématique d'un deuxième mode de réalisation d'un dispositif de conversion d'énergie mécanique vibratoire en énergie électrique 1. Comme dans le mode de réalisation précédant, le dispositif 1 comprend un support 5 et une masse mobile 6, logée dans un évidement du support 5. Une première poutre 200, une deuxième poutre 100 et une troisième poutre 300 s'étendent longitudinalement entre le support 5 et la masse mobile 6. Les poutres 100, 200 et 300 présentent des extrémités respectives 101, 201, 301 encastrées dans le support 5 et des extrémités respectives 102, 202, 302 encastrées dans la masse mobile 6. Les poutres 100 et 300 sont en matériau piézo-électrique. Le matériau piézo-électrique présente une polarisation sensiblement longitudinale. Ainsi, une tension électrique est générée entre les extrémités 101 et 102 ou 301 et 302 lorsque les poutres 100 ou 300 sont soumises à une traction ou à une compression longitudinale. Les extrémités des poutres 100 et 300 sont connectées de façon appropriée à un circuit à alimenter et à un circuit de commande de fréquence de résonance.

Un élément de jonction 400 est disposé entre les poutres 100 et 200. De façon similaire, un élément de jonction 800 est disposé entre les poutres 200 et 300. L'association des poutres 100, 200, 300 et des organes de jonction 400 et 800 forme une poutre 7. La poutre 7 ainsi formée présente un plan de symétrie longitudinal (x, y). Un plan de symétrie permet de connecter électriquement les extrémités des poutres ensemble, l'amplitude de la traction dans l'une étant proche de l'amplitude de la compression dans l'autre lors d'une flexion, les contraintes générées sur les poutres 100 et 300 sont donc similaires en amplitude (opposées en signe, mais que l'on peut compenser en inversant le sens de la polarisation piézoélectrique d'une poutre par rapport à l'autre). L'élément de jonction 400 correspond au volume présent entre les poutres 100 et 200 et l'élément de jonction 800 correspond au volume présent entre les poutres 200 et 300. Ces volumes sont identifiés par les lignes en pointillés. L'élément de jonction 400 s'étend entre les poutres 100 et 200. L'élément de jonction 800 s'étend entre les poutres 200 et 300. L'élément de jonction 400 est configuré pour maintenir un écartement entre les première et deuxième poutres 200 et 100. De façon similaire, l'élément de jonction 800 est configuré pour maintenir un écartement entre les première et troisième poutres 200 et 300. Les éléments de jonction 400 et 800 sont configurés de sorte que la raideur à la flexion de la poutre 7 autour de l'axe y soit au moins le double de la raideur à la flexion de cette poutre 7 dépourvue de poutre 100 ou de poutre 300. Ainsi, la poutre 100 et la poutre 300 ont une incidence prépondérante sur la raideur à la flexion de la poutre 7.

Les organes de jonction 400 et 800 sont formés d'une alternance de saillies respectives 401, 801 s'étendant selon la direction z et d'évidements respectifs 402, 802. Dans cet exemple, les évidements 402 et 802 ont une section en trapèze rectangle. Les saillies 401 et 801 sont formées monoblocs avec la poutre 200. La poutre 100 est fixée sur les extrémités des saillies 401, par exemple par collage. De façon similaire, la poutre 300 est fixée sur les extrémités des saillies 801.

La masse mobile 6 est maintenue suspendue par l'intermédiaire de la poutre 7 dans l'évidement ménagé dans le support 5. La poutre 7 est configurée pour fléchir autour d'un axe de direction y sous l'effet du mouvement relatif entre la masse mobile 6 et le support 5 selon la direction z.

Du fait de la symétrie de la poutre 7, lors du déplacement de la masse mobile 6 et de la flexion de la poutre 7, la fibre neutre de la poutre 7 se situe à l'intérieur de la poutre 200. Ainsi, la poutre 200 est soumise à des contraintes de traction/compression réduites lors d'une flexion de la poutre 7, ces contraintes de traction/compression étant concentrées dans les poutres 100 et 300. La récupération d'énergie et l'incidence d'une variation de raideur de ces poutres 100 et 300 sur la fréquence de résonance sont ainsi optimisées.

La première poutre 200 présente une raideur en élongation selon la direction longitudinale supérieure à la raideur en élongation des poutres 100 et 300 selon la direction longitudinale. La poutre 200 comporte un module d'élasticité élevé assurant un facteur de qualité élevé au résonateur mécanique formé. La première poutre 200 pourra être formée dans un matériau tel que du silicium ou de l'acier présentant un module d'élasticité supérieur à 100 GPa. Les poutres 100 et 300 pourront notamment être formées dans des matériaux tels que du PZT ou du BaTiO₃. Les poutres 100, 200 et 300 pourront présenter sensiblement une forme de plaques. Ces plaques pourront par exemple présenter une épaisseur comprise entre 50 et 250 µm et pourront présenter une longueur comprise entre 5 et 50 mm.

La différence de raideur entre la poutre 200 et les poutres 100 et 300 peut être ajustée afin d'assurer une protection des poutres piézo-électriques 100 et 300 contre une contrainte supérieure à leur seuil de dépolarisation, en limitant le pivotement de la masse mobile 6 autour d'un axe y lors de son déplacement selon l'axe z.

La poutre 7 présente avantageusement une raideur face à une flexion autour de l'axe z nettement supérieure à la raideur face à la flexion autour de l'axe y. Avantageusement, les poutres 100, 200 et 300 sont sensiblement rectilignes ou planes et s'étendent selon des directions convergeant à l'intérieur de la masse mobile, de préférence au niveau du centre de gravité de la masse mobile 6. Avantageusement, la masse mobile 6 présente une masse nettement supérieure à la masse de la poutre 7. Avantageusement, le support 5, la masse mobile 6, la poutre 200 et les saillies 401 et 802 sont formés d'un seul tenant, par exemple dans un substrat de silicium ou d'acier.

Avantageusement, les poutres 100 et 300 sont inclinées par rapport à la poutre 200 et inclinées par rapport à la direction x. Par une inclinaison appropriée des poutres 100 et 300, une flexion de la poutre 7 conduit à des contraintes sensiblement homogènes de traction/compression dans ces poutres 100 et 300.

Le circuit de commande de la fréquence de résonance comporte une charge électrique d'impédance réglable. En fonction de la fréquence de résonance mécanique souhaitée, le circuit de commande adapte l'impédance connectée aux bornes des poutres piézo-électriques 100 et 300. Une impédance maximale aux bornes de la poutre piézo-électrique 100 définit une fréquence de résonance mécanique maximale, tandis qu'une impédance minimale aux bornes des poutres piézo-électriques 100 et 300 définit une fréquence de résonance mécanique minimale.

L'ajustement de la fréquence de résonance peut également être réalisé en appliquant une tension électrique aux bornes des poutres piézoélectriques 100 et 300. Cette tension électrique a d'une part pour effet de modifier le module d'élasticité des matériaux piézoélectriques, mais aussi de créer des contraintes mécaniques de traction/compression dans les différentes poutres : si les poutres piézoélectriques 100 et 300 s'allongent sous l'effet d'une tension électrique, cette allongement va tendre à étirer la poutre centrale 200 qui par contre réaction va induire une contrainte de compression dans les poutres piézoélectriques 100 et 300. Ces contraintes de traction/compression peuvent engendrer, de par la non-linéarité des matériaux, un changement de la fréquence de résonance de la poutre 7.

Il est possible de récupérer de l'énergie tout en imposant une tension moyenne d'ajustement. En effet, la raideur moyenne de la structure sera liée à la valeur moyenne de la tension aux bornes des matériaux piézoélectriques. Cette valeur de tension moyenne peut alors être ajustée, soit en injectant une quantité de charges électriques donnée dans la poutre piézoélectrique, soit à partir d'une source de tension variable reliée à la poutre piézoélectrique par une résistance de forte valeur. Une telle résistance forme un filtre passe bas avec la capacité des poutres piézoélectriques. La fréquence de coupure de ce filtre passe-bas est inférieure à la fréquence de vibration de sorte que la vibration puisse induire une superposition d'une composante alternative à cette composante continue. L'énergie de cette composante alternative peut alors être récupérée, soit via une capacité de liaison qui la ramène autour de zéro volts et qui peut ensuite être redressée et convertie en une tension/courant utilisable par l'application, soit par une autre méthode, adaptée aux particularités des besoins de l'application.

La figure 5 est une vue en coupe longitudinale schématique d'une variante du deuxième mode de réalisation d'un dispositif de conversion 1. Cette variante se distingue de la variante de la figure 4 par des évidements 402 et 408 de section circulaire.

La figure 6 est une vue en coupe longitudinale schématique d'une autre variante du deuxième mode de réalisation d'un dispositif de conversion 1. Cette variante se distingue de la variante de la figure 4 par des évidements 402 et 408 de section en forme de quadrilatère divergeant en s'éloignant de la poutre 200.

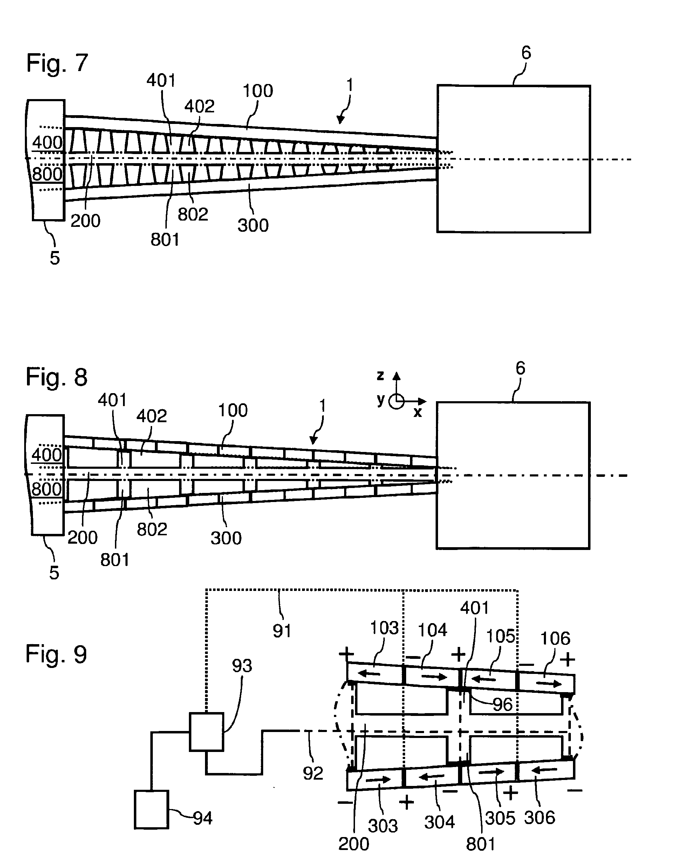

La figure 7 est une vue en coupe longitudinale schématique d'encore une autre variante du deuxième mode de réalisation d'un dispositif de conversion 1. Cette variante se distingue de la variante de la figure 4 par des évidements 402 et 408 de section en forme de quadrilatère convergeant en s'éloignant de la poutre 200.

La figure 8 est une vue en coupe longitudinale schématique d'un troisième mode de réalisation d'un dispositif de conversion d'énergie mécanique vibratoire en énergie électrique 1. La figure 9 est une représentation partielle de ce mode de réalisation et de ses connectiques avec des circuits électriques. Ce dispositif 1 diffère du deuxième mode de réalisation par la structure des poutres 100 et 300. Dans ce mode de réalisation, les poutres 100 et 300 sont formées par l'assemblage d'une succession longitudinale de composants piézo-électriques. Les composants piézo-électriques des poutres 100 et 300 présentent une polarisation orientée selon l'axe respectif de ces poutres 100 et 300. Deux composants piézo-électriques successifs présentent une polarisation opposée. Chaque composant piézo-électrique de la poutre 100 présente une polarisation opposée à la polarisation du composant piézo-électrique disposé à l'aplomb dans la poutre 300 (au même niveau longitudinal). Les composants piézo-électriques successifs d'une même poutre 100 ou 300 sont assemblés ensemble par l'intermédiaire d'une colle afin de pouvoir transmettre entre eux des efforts de traction et de compression. Chaque composant piézo-électrique présente une extrémité fixée à une saillie d'un élément de jonction et une extrémité fixée à l'aplomb d'un évidement de ce même élément de jonction. Dans l'exemple, les composants piézo-électriques 103, 104, 105 et 106 ont leur extrémité à polarité positive fixée sur des saillies et leur extrémité à polarité négative fixée à l'aplomb d'évidements. Les composants piézo-électriques 303, 304, 305 et 306 présentent leur extrémité à polarité négative fixée sur des saillies et leur extrémité à polarité positive fixée à l'aplomb d'évidements.

Les composants piézo-électriques sont fixés aux saillies des éléments de jonction 400 et 800 par l'intermédiaire d'une colle conductrice 96, par exemple la même colle utilisée pour assembler les composants piézo-électriques successifs. Les extrémités à polarité positive des composants de la poutre 100 sont connectées aux extrémités à polarité négative des composants de la poutre 300. Cette opposition de polarité n'est pas gênante dans la mesure où une flexion induit simultanément une traction dans une poutre piézo-électrique et une compression sensiblement de même amplitude dans l'autre poutre piézo-électrique. Les extrémités des composants piézo-électriques connectées ensemble sont donc sensiblement au même potentiel. Les extrémités des composants piézo-électriques fixées auxdites saillies peuvent être connectées électriquement à un conducteur électrique 92, par l'intermédiaire de pistes ménagées dans les saillies 401,801 et la poutre 200, ou directement par conduction à travers ces saillies 401,801 et la poutre 200 (réalisés par exemple en silicium dopé conducteur ou en acier). Les extrémités des composants piézo-électriques fixés à l'aplomb des évidements sont connectées électriquement à un conducteur électrique 91 par l'intermédiaire d'un câblage approprié. Les conducteurs électriques 91 et 92 sont connectés à des bornes respectives d'un circuit 93 destiné à la fois à être alimenté par la déformation des poutres 100 et 300 et à contrôler la raideur de ces poutres 100 et 300 au moyen d'une impédance variable ou d'une tension électrique de polarisation. Un circuit de commande 94 est connecté au circuit 93 afin de définir l'impédance de ce circuit 93 ou d'imposer une tension de polarisation, et ainsi de définir la fréquence de résonance mécanique du dispositif 1.

Ce mode de réalisation permet de réduire la tension maximale générée par les poutres 100 et 300, cette tension étant proportionnelle à la longueur d'un élément piézoélectrique dans le sens de sa polarisation, et ainsi éviter un éventuel arc électrique. Ce mode de réalisation permet aussi d'augmenter la capacité globale du dispositif de conversion 1, la longueur des poutres 100 et 300 étant divisée en N éléments piézoélectriques, la capacité de chaque élément est multipliée par N et si les N éléments sont placés électriquement en parallèle, on multiplie encore par N la capacité globale connectée à la charge électrique et on rend encore plus négligeables toutes les capacités parasites du circuit électrique et des connexions. Ce mode de réalisation se montre particulièrement avantageux dans le cas où les poutres 100 et 300 présentent une inclinaison optimale garantissant une homogénéité de contrainte lors de la flexion de la poutre 7. Les extrémités des différents composants piézo-électriques peuvent alors être connectées ensemble sans subir un effet néfaste de composants piézoélectriques moins contraints et formant des capacités parasites.

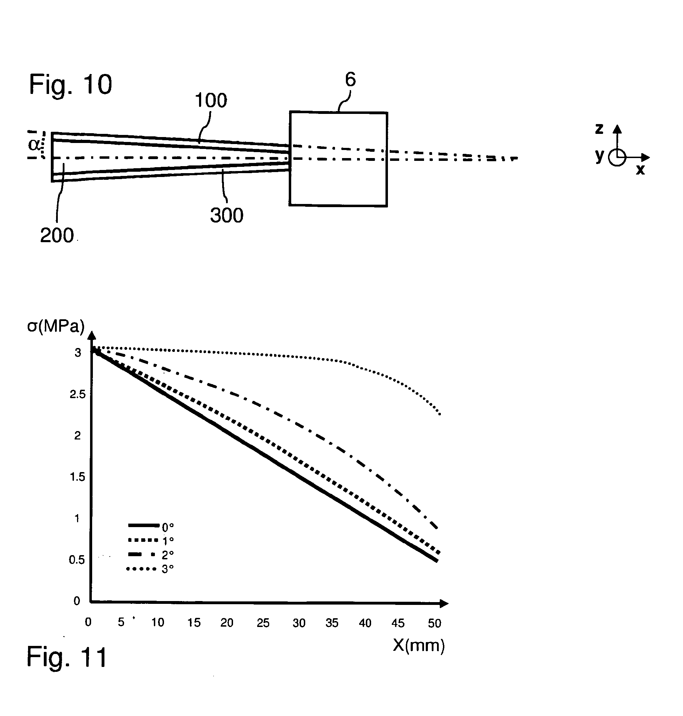

La figure 10 est une vue de côté d'un modèle simplifié de dispositif de conversion, utilisé pour déterminer un angle d'inclinaison α optimal des poutres piézoélectriques afin d'obtenir une homogénéité de contraintes lors d'une flexion. La modélisation a été effectuée avec une poutre 200 pleine joignant les poutres 100 et 300, et des poutres 100 et 300 d'épaisseur constante.

La masse mobile 6 de l'exemple est en acier et présente les dimensions suivantes: longueur de 20 mm, largeur 20 mm, hauteur de 20 mm.

La poutre 200 est en acier et présente les dimensions suivantes : longueur de 50 mm, largeur 20 mm et épaisseur comprise entre 0.78 et 6 mm.

Les poutres 100 et 300 présentent un module d'élasticité de 62 GPa, une densité de 7,85, une permittivité relative de 880 et un coefficient piézo-électrique de 2,95.10⁻⁹ C/N. Les poutres 100 et 300 présentent les dimensions suivantes : une longueur de 50 mm, une largeur de 10 mm, et une épaisseur de 1 mm.

Le diagramme de la figure 11 illustre la répartition de la contrainte de traction ou de compression à la surface d'une poutre piézo-électrique 100 ou 300 lors de l'application d'une même flexion. La valeur X correspond à la distance de la masse mobile à laquelle la contrainte est mesurée. Comme illustré dans le diagramme, on constate que la contrainte dans la poutre piézo-électrique est sensiblement homogène pour un angle α de 3°. Ainsi, on utilisera avantageusement des poutres 100 et 300 formant un angle compris entre 2 et 4° par rapport à la poutre 200.

Dans les exemples illustrés, la polarisation des poutres piézoélectriques est longitudinale. Cependant, on peut également envisager d'utiliser des poutres piézoélectriques dans lesquelles la polarisation a la direction de leur épaisseur. Une telle polarisation limite par contre la variation de raideur possible pour les poutres piézoélectriques, et ainsi la plage de variation de la fréquence de résonance mécanique. Une telle polarisation permet toutefois de disposer d'une capacité électrique plus importante, ce qui limite l'incidence des capacités parasites. Une telle polarisation permet également de limiter la tension électrique dans les poutres piézoélectriques pour limiter les risques de claquage diélectrique par l'extérieur.

Dans les exemples illustrés, la raideur en flexion des éléments de jonction 400 et 800 est diminuée au moyen d'évidements réalisés dans un matériau à fort facteur de qualité. Cependant, l'invention peut également être mise en oeuvre en utilisant des éléments de jonction 400 ou 800 comprenant une couche de matériau continu présentant un module d'élasticité très inférieur au module d'élasticité de la poutre 100. On peut ne pas non plus tenir compte des électrodes des poutres piézoélectriques qui peuvent être réalisées dans un matériau de module d'Young élevé (tungstène, platine ou autres) mais dont l'épaisseur est si faible (< 1 µm) que leur contribution à la raideur à la flexion globale peut être considérée comme négligeable.

## Revendications

1. Dispositif de conversion d'énergie mécanique vibratoire en énergie électrique (1), comprenant :
- une masse mobile (6) ;
- un support (5) ;
- une première poutre (200) s'étendant longitudinalement entre le support (5) et la masse mobile (6), la première poutre (200) ayant ses extrémités (201,202) encastrées respectivement dans le support (5) et dans la masse mobile (6), la première poutre présentant une première raideur en élongation selon la direction longitudinale ;
**Caractérisé en ce qu'**il comprend en outre :
- une deuxième poutre (100) en matériau piézo-électrique s'étendant longitudinalement entre le support (5) et la masse mobile (6), le support et la masse mobile étant reliés par l'intermédiaire de la deuxième poutre, la deuxième poutre présentant une deuxième raideur en élongation selon la direction longitudinale inférieure à la première raideur ;
- un premier élément de jonction (400) s'étendant entre les première et deuxième poutres, cet élément de jonction maintenant l'écartement entre les première et deuxième poutres, la raideur à la flexion de l'ensemble comportant la première poutre, la deuxième poutre et l'élément de jonction étant au moins double de la raideur à la flexion de ce même ensemble dépourvu de la deuxième poutre.

2. Dispositif de conversion d'énergie selon la revendication 1, dans lequel le premier élément de jonction (400) comprend une série de saillies (401) s'étendant entre la première poutre (200) et la deuxième poutre (100), les saillies étant formées d'un seul tenant avec la première poutre et étant séparées par des évidements (402).

3. Dispositif de conversion d'énergie selon la revendication 1, dans lequel le premier élément de jonction comprend une couche de matériau joignant la première poutre (200) à la deuxième poutre (100) et présentant une raideur en élongation inférieure à la deuxième raideur en élongation.

4. Dispositif de conversion d'énergie selon l'une quelconque des revendications précédentes, dans lequel les première et deuxième poutres (200, 100) s'étendent de façon sensiblement rectiligne selon des directions convergeant à l'intérieur de la masse mobile (6).

5. Dispositif de conversion d'énergie selon la revendication 4, dans lequel la deuxième poutre (100) forme un angle compris entre 2 et 4° par rapport à la première poutre (200).

6. Dispositif de conversion d'énergie selon l'une quelconque des revendications précédentes, dans lequel la masse mobile (6) est maintenue suspendue dans un évidement du support par l'intermédiaire desdites première et deuxième poutres.

7. Dispositif de conversion d'énergie selon l'une quelconque des revendications précédentes, dans lequel la deuxième poutre (100) comprend deux bornes de connexion au niveau de polarités piézoélectriques opposées, le dispositif comprenant en outre un circuit électrique (93) connecté entre lesdites deux bornes de connexion.

8. Dispositif de conversion d'énergie selon la revendication 7, dans lequel le circuit électrique (93) présente un amortissement électrique sensiblement égal à l'amortissement mécanique d'une structure incluant la masse mobile, la première poutre, la deuxième poutre et l'élément de jonction.

9. Dispositif de conversion d'énergie selon la revendication 7 ou 8, dans lequel le circuit électrique (93) présente une impédance variable, le dispositif comprenant en outre un circuit de commande (94) apte à modifier l'impédance dudit circuit électrique (93).

10. Dispositif de conversion d'énergie selon la revendication 7 ou 8, dans lequel le circuit électrique présente une tension à ses bornes réglable, le dispositif comprenant en outre un circuit de commande apte à modifier la tension aux bornes dudit circuit électrique.

11. Dispositif de conversion d'énergie selon l'une quelconque des revendications précédentes, dans lequel le matériau piézo-électrique de la deuxième poutre (100) est polarisé selon la direction longitudinale de cette poutre.

12. Dispositif de conversion d'énergie selon la revendication 11, dans lequel la deuxième poutre comprend une succession d'éléments piézoélectriques fixés ensemble, deux éléments piézoélectriques successifs présentant des polarisations opposées.

13. Dispositif de conversion d'énergie selon l'une quelconque des revendications précédentes, comprenant en outre :
- une troisième poutre (300) en matériau piézo-électrique s'étendant longitudinalement entre le support (5) et la masse mobile (6), la troisième poutre ayant ses extrémités encastrées (301,302) respectivement dans le support et dans la masse mobile, la troisième poutre (300) présentant une troisième raideur en élongation selon la direction longitudinale inférieure à la première raideur;
- un deuxième élément de jonction (800) s'étendant entre les première et deuxième poutres, cet élément de jonction maintenant l'écartement entre les première et troisième poutres, la raideur à la flexion de l'ensemble comportant la première poutre, la deuxième poutre, la troisième poutre et les éléments de jonction étant au moins double de la raideur à la flexion de ce même ensemble dépourvu de la deuxième poutre.

14. Dispositif de conversion d'énergie selon la revendication 13, dans lequel le système comprenant les première à troisième poutres, les premier et deuxième éléments de jonction et la masse mobile présente un plan de symétrie longitudinal tel que la deuxième poutre est symétrique à la troisième poutre par rapport à ce plan.

## Patentansprüche

1. Vorrichtung zur Umwandlung mechanischer Vibrationsenergie in elektrische Energie (1), die folgendes beinhaltet:
- eine bewegliche Masse (6)
- eine Stütze (5)
- einen ersten Balken (200), der sich längs zwischen der Stütze (5) und der beweglichen Masse (6) erstreckt, die Enden (201, 202) des ersten Balkens (200) sind entsprechend in die Stütze (5) und in die mobile Masse (6) eingefügt, der erste Balken weist eine erste Elongationsversteifung in der Längsrichtung auf;
**dadurch gekennzeichnet, daß** sie desweiteren beinhaltet:
- einen zweiten Balken (100) aus piezoelektrischem Material, der sich längs zwischen der Stütze (5) und der mobilen Masse (6) erstreckt, die Stütze und die mobile Masse sind hierbei über den zweiten Balken verbunden und der zweite Balken weist eine zweite Elongationsversteifung in der Längsrichtung, die geringer als die ersten Elongationsversteifung in der Längsrichtung ist;
- ein erstes Verbindungselement (400), das sich zwischen dem ersten und dem zweiten Balken erstreckt, dieses Verbindungselement erhält den Abstand zwischen dem ersten und dem zweiten Balken aufrecht, und die Versteifung in der Flexion des den ersten Balken, der zweite Balken und das Verbindungselement umfassenden Ganzen, ist hierbei mindestens doppelt so stark als die Versteifung in der Flexion desselben Ganzen, als es ohne zweiten Balken wäre.

2. Vorrichtung zur Energieumwandlung gemäß Anspruch 1, bei dem das erste Verbindungselement (400) eine Reihe von Ausladungen (401) enthält, die sich zwischen dem ersten Balken (200) und dem zweiten Balken (100) erstrecken, die Ausladungen sind aus einem Stück mit dem ersten Balken gebildet und werden durch Vertiefungen (402) getrennt.

3. Vorrichtung zur Energieumwandlung gemäß Anspruch 1, bei dem das erste Verbindungselement eine Materialschicht enthält, die den ersten Balken (200) mit dem zweiten Balken (100) verbindet und eine Versteifung in der Elongation aufweist, die geringer ist als die zweite Elongationsversteifung.

4. Vorrichtung zur Energieumwandlung gemäß irgendeinem der vorangegangenen Ansprüche, bei der der erste und zweite Balken (200,100) sich auf deutlich geradlinige Weise hinsichtlich konvergierender Richtungen im Inneren der mobilen Masse (6) erstrecken.

5. Vorrichtung zur Energieumwandlung gemäß Anspruch 4, bei der der zweite Balken (100) einen im Vergleich zum ersten Balken (200) zwischen 2 und 4° gelegenen Winkel bildet.

6. Vorrichtung zur Energieumwandlung gemäß irgendeinem der vorangegangenen Ansprüche, bei der die mobile Masse (6) aufgehängt zwischen einer Vertiefung der Stütze durch die genannten ersten und zweiten Balken gehalten wird.

7. Vorrichtung zur Energieumwandlung gemäß irgendeinem der vorangeganenen Ansprüche, bei der der zweite Balken (100) zwei Anschlussklemmen auf der Ebene gegenüberliegender piezoelektrischer Polaritäten enthält, die Vorrichtung umfasst weiterhin einen elektrischen Stromkreis (93), der zwischen den beiden genannten Anschlussklemmen angeschlossen ist.

8. Vorrichtung zur Energieumwandlung gemäß Anspruch 7, bei der der Stromkreis (93) eine elektrische Dämpfung aufweist, die eindeutig gleich ist wie die mechanische Dämpfung mit einer Struktur, die die mobile Masse, den ersten Balken, den zweiten Balken und das Verbindungselement miteinschließt.

9. Vorrichtung zur Energieumwandlung gemäß Anspruch 7 oder 8, bei der der Stromkreis (93) eine variable Impedanz aufweist, die Vorrichtung umfasst des weiteren eine Steuerleitung (94), die dazu geeignet ist, die Impedanz des genannten Stromkreises (93) zu verändern.

10. Vorrichtung zur Energieumwandlung gemäß Anspruch 7 und 8, bei der der Stromkreis eine regulierbare Spannung aufweist, die Vorrichtung enthält des weiteren eine Steuerleitung, die dazu geeignet ist, die Spannung in den Klemmen des genannten Stromkreises zu verändern.

11. Vorrichtung zur Energieumwandlung gemäß irgendeinem der vorangegangenen Ansprüche, bei der das piezoelektrische Material des zweiten Balkens (100) in länglicher Richtung dieses Balkens polarisiert ist.

12. Vorrichtung zur Energieumwandlung gemäß Anspruch 11, bei der der zweite Balken eine Reihe von zusammen befestigten piezoelektrischen Elementen umfasst und zwei aufeinanderfolgende piezoelektrische Elemente gegenüberliegende Polarisationen darstellen.

13. Vorrichtung zur Energieumwandlung gemäß irgendeinem der vorangegangenen Ansprüche, die weiterhin folgendes umfasst:
- einen dritten Balken (300) aus piezoelektrischem Material, der sich in Längsrichtung zwischen der Stütze (5) und der mobilen Masse (6) erstreckt, die Enden (301, 302) dieses dritten Balkens sind entsprechend in der Stütze sowie der mobilen Masse eingefügt, der dritte Balken (300) weist eine dritte Elongationsversteifung in der Längsrichtung auf, die geringer ist als die erste Versteifung;
- ein zweites Verbindungselement (800), das sich zwischen den ersten und zweiten Balken erstreckt, dieses Verbindungselement erhält den Abstand zwischen dem ersten und dem zweiten Balken aufrecht, die Biegungsversteifung, des aus dem ersten Balken, aus dem zweiten Balken, aus dem dritten Balken und aus der Verbindungselemente bestehenden Ganzen, ist mindestens doppelt so stark wie die Biegungsversteifung dieses selben Ganzen ohne den zweiten Balken.

14. Vorrichtung zur Energieumwandlung gemäß Anspruch 13, bei der das System, das die ersten bis dritten Balken, die ersten und zweiten Verbindungselemente und die mobile Masse umfasst, eine längliche Symmetrieebene aufweist wie etwa der zweite Balken in Bezug auf diese Ebene symmetrisch zum dritten Balken ist.

## Claims

1. Device for converting vibratory mechanical energy into electrical energy (1), comprising:
- a mobile mass (6);
- a support (5);
- a first beam (200) extending lengthways between the support (5) and the mobile mass (6), the first beam (200) with its ends (201,202) built into the support (5) and the mobile mass respectively (6), the first beam exhibiting a first elongation stiffness along the longitudinal direction;
It is also **characterised by**:
- a second beam (100) made of piezoelectrical material extending lengthways between the support (5) and the mobile mass (6), the support and the mobile mass being linked by the second beam, the second beam exhibiting a second elongation stiffness along the longitudinal direction that is lower than the first stiffness;
- a first junction element (400) extending between the first and second beams, this junction element maintaining the spacing between the first and second beams, the bending stifness of the assembly comprising the first beam, the second beam and the junction element being at least double the bending stiffness of this same assembly devoid of the second beam.

2. Device for energy conversion according to claim 1 in which the first junction element (400) comprises a series of projections (401) extending between the first beam (200) and the second beam (100), the projections being formed all in one block with the first beam and being separated by recesses (402).

3. Device for energy conversion according to claim 1, in which the first junction element comprises a layer of material joining the first beam (200) to the second beam (100) and exhibiting an elongation stiffness which is less than the second elongation stiffness.

4. Device for energy conversion according to any preceding claim in which the first and second beams (200, 100) extend roughly rectilinearly along directions converging inside the mobile mass (6).

5. Device for energy conversion according to claim 4 in which the second beam (100) forms an angle of between 2° and 4° degrees relative to the first beam (200).

6. Device for energy conversion according to any preceding claims in which the mobile mass (6) is held suspended in a recess of the support by means of the above first and second beams.

7. Device for energy conversion according to any preceding claims in which the second beam (100) comprises two connecting terminals at opposite piezoelectric polarities, the device further comprising an electric circuit (93) connected between the two above terminal connections.

8. Device for energy conversion according to claim 7 in which the electric circuit (93) has an electrical damping which is roughly equal to the mechanical damping of a structure which includes the mobile mass, the first beam, the second beam and the junction element.

9. Device for energy conversion according to claim 7 or 8 where the electrical circuit (93) exhibits a variable impedance, the apparatus further comprising a control circuit (94) capable of varying the impedance of the above electrical circuit (93).

10. Device for energy conversion according to claim 7 or 8 in which the electrical circuit has an adjustable voltage at its terminals, the apparatus further comprising a control circuit capable of varying the voltage to the terminals of the above electrical circuit.

11. Device for energy conversion according to any of the preceding claims in which the piezoelectrical material of the second beam (100) is polarised according to the lengthways direction of this beam.

12. Device for energy conversion according to claim 11 in which the second beam comprises a series of piezoelectrical elements secured together, the two piezoelectrical elements having opposite polarisations.

13. Device for energy conversion according to any one of the preceding claims further comprising:
- a third beam (300) of piezoelectrical material extending lengthways between the support (5) and the mobile mass (6), the third beam having its ends built into (301, 302) the support and mobile mass respectively, the third beam (300) having a third elongation stiffness along the longitudinal direction which is less than the first stiffness;
- a second junction element (800) extending between the first and second beams, this junction element maintaining the spacing between the first and third beams, the bending stiffness of the assembly comprising the first beam, the second beam, the third beam and the junction elements being at least twice the bending stiffnessof this same assembly devoid of the second beam.

14. Device for energy conversion according to claim 13 in which the system comprising the first to third beams, the first and second junction elements and the mobile mass has a longitudinal symmetrical plane such that the second beam is symmetrical to the third beam in respect of this plane.
